(19) Europäisches Patentamt
European Patent Office
Office européen des brevets

(11) **EP 2 446 530 B1**

## (12) EUROPEAN PATENT SPECIFICATION

(45) Date of publication and mention
of the grant of the patent:
**23.04.2014  Bulletin 2014/17**

(21) Application number: **10734383.2**

(22) Date of filing: **22.06.2010**

(51) Int Cl.:
*H03F 1/32* *(2006.01)*    *H03F 1/34* *(2006.01)*

(86) International application number:
**PCT/US2010/039553**

(87) International publication number:
**WO 2010/151557 (29.12.2010 Gazette 2010/52)**

(54) **METHOD AND APPARATUS FOR USING PRE-DISTORTION AND FEEDBACK TO MITIGATE NONLINEARITY OF CIRCUITS**

VERFAHREN UND VORRICHTUNG FÜR DEN EINSATZ VON VORVERZERRUNG UND RÜCKKOPPLUNG ZUR UNTERDRÜCKUNG VON NICHTLINEARITÄTEN BEI SCHALTKREISEN

PROCÉDÉ ET APPAREIL D'UTILISATION DE PRÉ-DISTORSION ET DE RÉTROACTION POUR LIMITER UNE NON-LINÉARITÉ DE CIRCUITS

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **22.06.2009  US 489380**

(43) Date of publication of application:
**02.05.2012  Bulletin 2012/18**

(73) Proprietor: **QUALCOMM Incorporated**
**San Diego, CA 92121 (US)**

(72) Inventors:
  • **APARIN, Vladimir**
  **San Diego**
  **CA 92121 (US)**
  • **BALLANTYNE, Gary, John**
  **San Diego**
  **CA 92121 (US)**

(74) Representative: **Wimmer, Hubert**
**WAGNER & GEYER**
**Gewürzmühlstrasse 5**
**80538 München (DE)**

(56) References cited:
**EP-A1- 1 562 285      EP-A1- 1 791 310**
**EP-A2- 1 653 630      US-A- 5 745 006**
**US-A- 6 043 707       US-A1- 2009 146 736**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**BACKGROUND**

**I. Field**

The present disclosure relates generally to electronics, and more specifically to techniques for mitigate nonlinearity of circuits.

**II. Background**

A circuit in an electronics device may be designed to perform a particular function such as amplification, filtering, frequency conversion, etc. It may be desirable for the circuit to have a linear function, so that an output signal is linearity related to an input signal. However, the circuit typically has some nonlinearity. The output signal would then include distortion components generated by the nonlinearity of the circuit. The distortion components may degrade performance. It may be desirable to mitigate the deleterious effects of the nonlinearity of the circuit in order to improve performance.

An example for a method of compensating for distortion in an amplifier using an error signal in combination with predistortion is given in US 5745006.

**BRIEF DESCRIPTION OF THE DRAWINGS**

[0004]

　　FIG. 1 shows a system with feedback to mitigate nonlinearity of a plant.
　　FIG. 2 shows another system with feedback to mitigate nonlinearity of a plant.
　　FIG. 3 shows a system with both pre-distortion and feedback to mitigate nonlinearity of a plant.
　　FIG. 4 shows another system with both pre-distortion and feedback.
　　FIG. 5 shows an exemplary design of an adaptive inverse model.
　　FIG. 6 shows a block diagram of a wireless communication device.
　　FIG. 7 shows a transmitter system with both pre-distortion and feedback.
　　FIG. 8 shows a process for generating an output signal with both pre-distortion and feedback.

**DETAILED DESCRIPTION**

The word "exemplary" is used herein to mean "serving as an example, instance, or illustration." Any design described herein as "exemplary" is not necessarily to be construed as preferred or advantageous over other designs.

Techniques for mitigating nonlinearity of circuits using both pre-distortion and feedback are described herein. Feedback refers to routing of an output signal from a circuit and injecting the signal at an input or an internal node of the circuit. Pre-distortion refers to pre-processing of a signal in a manner to attenuate undesired distortion components generated by nonlinearity of the circuit. Pre-distortion typically has a wide bandwidth but may not be robust, e.g., with respect to modeling errors. On the other hand, feedback is typically robust but normally has a narrow bandwidth due to stability considerations. The combination of pre-distortion and feedback may provide the wide bandwidth advantage of pre-distortion with the robustness of feedback.

The techniques described herein may be used to mitigate nonlinearity of various types of circuit. For clarity, the techniques are first described for a generic system and then described for a specific system, which is a radio frequency (RF) transmitter.

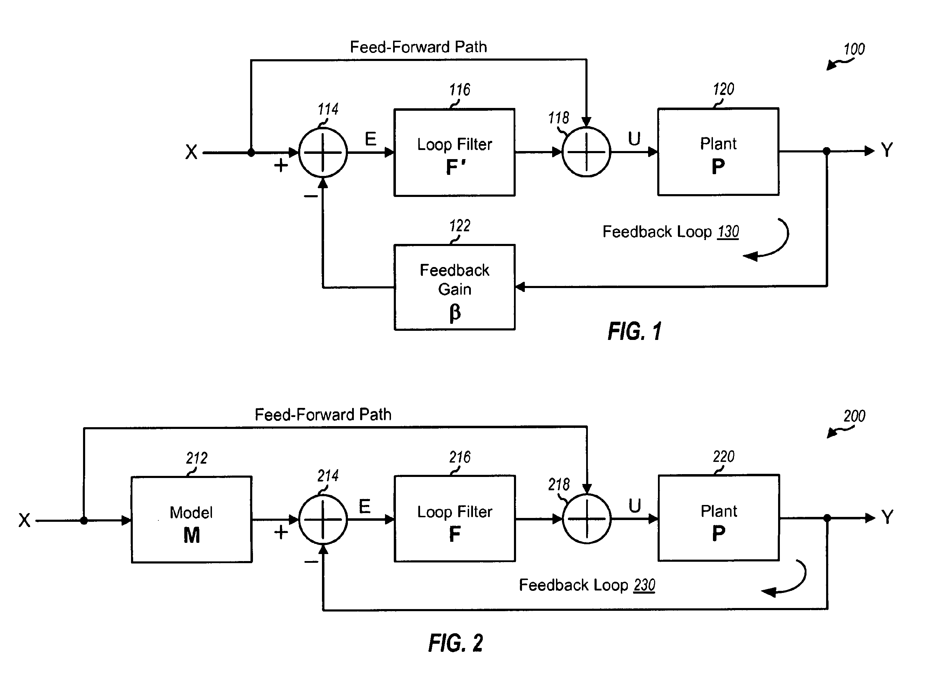

**FIG. 1** shows a block diagram of an exemplary design of a system 100 with feedback to mitigate nonlinearity of a plant 120. Plant 120 may be any circuit having nonlinearity to be mitigated. Within system 100, an input signal (denoted as X) is provided to both summers 114 and 118. Summer 114 subtracts a feedback signal provided by a feedback block 122 from the input signal and provides an error signal (denoted as E). A loop filter 116 filters the error signal with a transfer function F' and provides a filtered error signal. Summer 118 sums the input signal with the filtered error signal and provides a combined signal. Plant 120 processes the combined signal with a transfer function P and provides an output signal (denoted as Y). Feedback block 122 scales the output signal with a feedback gain $\beta$ and provides the feedback signal.

System 100 includes a feed-forward path from the input signal to summer 118. System 100 also includes a feedback loop 130, which is formed from the output signal Y through block 122, summer 114, loop filter 116, summer 118, and plant 120.

The input signal X may be a complex signal comprising a real/inphase (I) component and an imaginary/quadrature (Q) component. For simplicity, FIG. 1 assumes that the transfer functions for the I and Q components can be decoupled and shows the loop for only one component.

Plant 120 represents a circuit having nonlinearity, e.g., an RF transmitter, a power amplifier, etc. The transfer function of plant 120 may be expressed as:

$$Y = g_1 \, U + g_3 \, |U|^2 \, U + g_5 \, |U|^4 \, U + ... \qquad\qquad Eq\ (1)$$

where

$g_1$ is a coefficient that defines the linear gain of the plant,
$g_3$ is a coefficient that defines the strength of third order nonlinearity,
$g_5$ is a coefficient that defines the strength of fifth order nonlinearity,
U is an input signal for the plant, and
|U| denotes the magnitude of the input signal for the plant.

For simplicity, equation (1) shows only the third and fifth order nonlinearities. The even order as well as higher order nonlinearities are omitted in equation (1). In general, the strength of the n-th order nonlinearity may be given as: $g_n |X|^{n-1} X$. Certain applications may be more concern with odd order nonlinearities whereas other applications may be more concerned with even order nonlinearities.

As shown in equation (1), the output signal Y may include a desired signal component $g_1 \cdot X$ as well as distortion components. The feedback in system 100 attempts to cancel the distortion components by feeding back the output signal, scaling this signal with the feedback gain $\beta$, subtracting the scaled signal from the input signal to obtain the error signal, and filtering the error signal to obtain the filtered error signal. Plant 120 scales the input signal X with the gain $g_1$ and also generates distortion components due to its nonlinearity. The filtered error signal from loop filter 116 attempts to generate correction components that are opposite of the distortion components, so that the output signal Y has attenuated distortion components. Feedback loop 130 can attenuate distortion components within its bandwidth and passes distortion components outside of the loop bandwidth. The loop bandwidth may be set such that stability of feedback loop 130 can be assured.

A transfer function for system 100 may be expressed as:

$$\frac{Y}{X} = P \left( \frac{1 + F'}{1 + F' \, \beta \, P} \right) . \qquad\qquad Eq\ (2)$$

As shown in equation (2), the desired transfer function for system 100 and the desired closed-loop characteristics of feedback loop 130 may be obtained by selecting the proper transfer function F' for loop filter 116 and the proper feedback gain $\beta$.

**FIG. 2** shows a block diagram of an exemplary design of a system 200 with feedback to mitigate nonlinearity of a plant 220. Within system 200, an input signal X is provided to both a model 212 and a summer 218. Model 212 processes the input signal with a transfer function M, which models the transfer function P of plant 220. A summer 214 subtracts an output signal provided by plant 220 from the signal provided by model 212 and outputs an error signal E. A loop filter 216 filters the error signal with a transfer function F and provides a filtered error signal. Loop filter 216 may be a lowpass filter having a bandwidth that may be selected to provide the desired closed-loop characteristics. Summer 218 sums the input signal with the filtered error signal and provides a combined signal. Plant 220 processes the combined signal with the transfer function P and provides the output signal.

System 200 includes a feed-forward path from the input signal to summer 218. System 200 also includes a feedback loop 230, which is formed from the output signal Y through summer 214, loop filter 216, summer 218, and plant 220.

A transfer function for system 200 may be expressed as:

$$\frac{Y}{X} = P \left( \frac{1 + F\,M}{1 + F\,P} \right). \qquad\qquad Eq\ (3)$$

As shown in equation (3), the desired transfer function for system 200 and the desired closed-loop characteristics of feedback loop 230 may be obtained by selecting the proper transfer function F for loop filter 216 and the proper transfer function M for model 212. As shown in equations (2) and (3), the transfer function for system 200 is equal to the transfer function for system 100 in FIG. 1 when M =1/$\beta$ and F = $\beta \cdot$ F'.

System 200 may be considered as having conditional feedback. In particular, if the transfer function for model 212 is equal to the transfer function for plant 220 (i.e., if M = P), then Y = P X and there is no feedback. Thus, if the transfer function of plant 220 is known, then the feedback loop will reject disturbances within its bandwidth, and the system output will follow the model output.

Model 212 may be designed to track changes in plant 220 using techniques from Model Reference Adaptive Control (MRAC). For example, plant 220 may be a nonlinear power amplifier with a complex gain of $Y = U + g_3 |U|^2\,U$, where X may be a complex input signal provided to the power amplifier. Coefficient $g_3$ of this polynomial may be adaptively determined and used in model 212 to mitigate third order nonlinearity of the power amplifier. However, this scheme would correct only the part of the nonlinearity that may be regarded as a disturbance falling within the loop bandwidth.

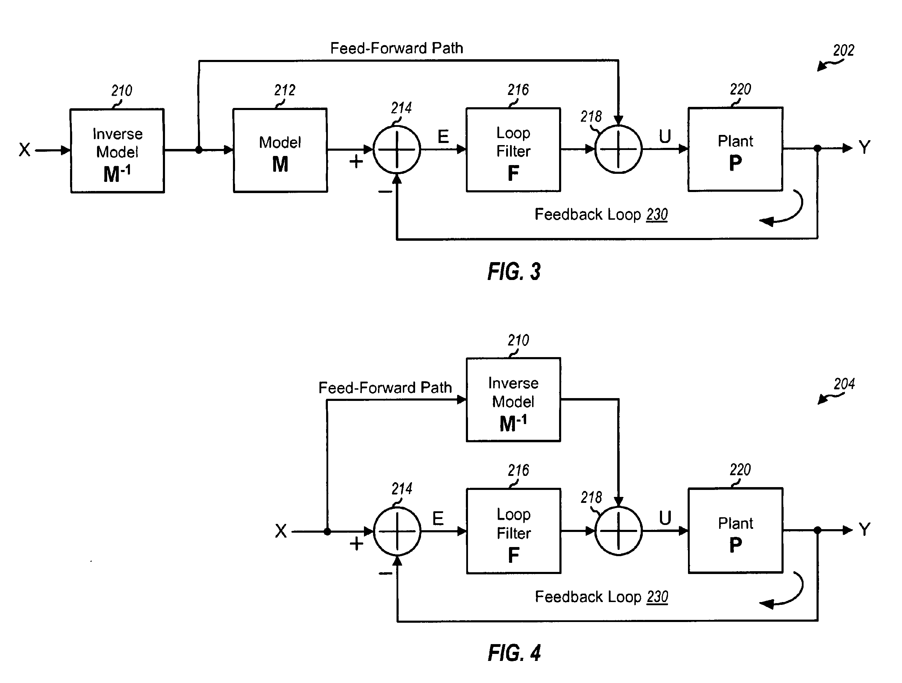

**FIG. 3** shows a block diagram of an exemplary design of a system 202 with both pre-distortion and feedback to mitigate nonlinearity of plant 220. System 202 includes all of blocks 212 through 220 in system 200 in FIG. 2. System 202 further includes an inverse model 210 having a transfer function $M^{-1}$, which is the inverse of the transfer function M of model 212. Inverse model 210 receives the input signal X, generates a pre-distorted signal based on the transfer function $M^{-1}$, and provides the pre-distorted signal to both model 212 and summer 218. The other blocks within system 202 operate as described above for FIG. 2.

In system 202, the transfer function M of model 212 may be adaptively determined. The inverse of the transfer function, $M^{-1}$, may then be determined and applied by inverse model 210 located at the input of system 202.

System 202 combines both pre-distortion and feedback. Feedback is employed to reject disturbances, and may have a relatively narrow bandwidth as well as relatively high stability margins. Pre-distortion may have a relatively wide bandwidth but may not be robust with respect to un-modeled plant disturbances or changes in the plant model. System 202 can address the problem of un-modeled plant disturbances with feedback and the problem of changes in the plant model with adaptive determination of the transfer function M.

**FIG. 4** shows a block diagram of an exemplary design of a system 204 with both pre-distortion and feedback to mitigate nonlinearity of plant 220. System 204 is a simplified version of system 202 in FIG. 3. In FIG. 3, inverse model 210 may be replicated, one copy of inverse model 210 may be placed in the feed-forward path, and another copy may be placed just before model 212. The combination of inverse model 210 and model 212 would be equal to one and may be removed. Only inverse model 210 in the feed-forward path would remain, as shown in FIG. 4.

System 204 includes the feed-forward path from the input signal through inverse model 210 to summer 218. Inverse model 210 receives the input signal X and provides a pre-distorted signal to summer 218. System 204 also includes feedback loop 230, which is formed from the output signal Y through summer 214, loop filter 216, summer 218, and plant 220.

A transfer function for systems 202 and 204 may be expressed as:

$$\frac{Y}{X} = P\,M^{-1} \left( \frac{1 + F\,M}{1 + F\,P} \right). \qquad\qquad Eq\ (4)$$

As shown in equation (4), if the transfer function for model 212 is equal to the transfer function for plant 220 (i.e., if M = P) and if the transfer function for inverse model 210 is equal to the inverse of the transfer function for plant 220 (i.e., if $M^{-1} = P^{-1}$), then Y = X and there is no distortion components. The nonlinearity of plant 220 may thus be mitigated by (i) estimating the transfer function P of plant 220 and determining its inverse or (ii) directly determining $M^{-1}$ based on an estimate of $P^{-1}$.

The transfer function of model 212 may be expressed as:

$$G \approx \frac{Y}{U} = g_1 + g_3 |U|^2 + g_5 |U|^4 + \dots . \qquad Eq\ (5)$$

The transfer function of inverse model 210 may be expressed as:

$$H = \frac{1}{G} = h_1 + h_3 |X|^2 + h_5 |X|^4 + \dots , \qquad Eq\ (6)$$

where $h_n$ is a coefficient for the n-th order nonlinearity of plant 220. Inverse model 210 may adaptively determine the inverse transfer function $M^{-1}$ such that $Y \approx g_1 X$ and the distortion components are attenuated.

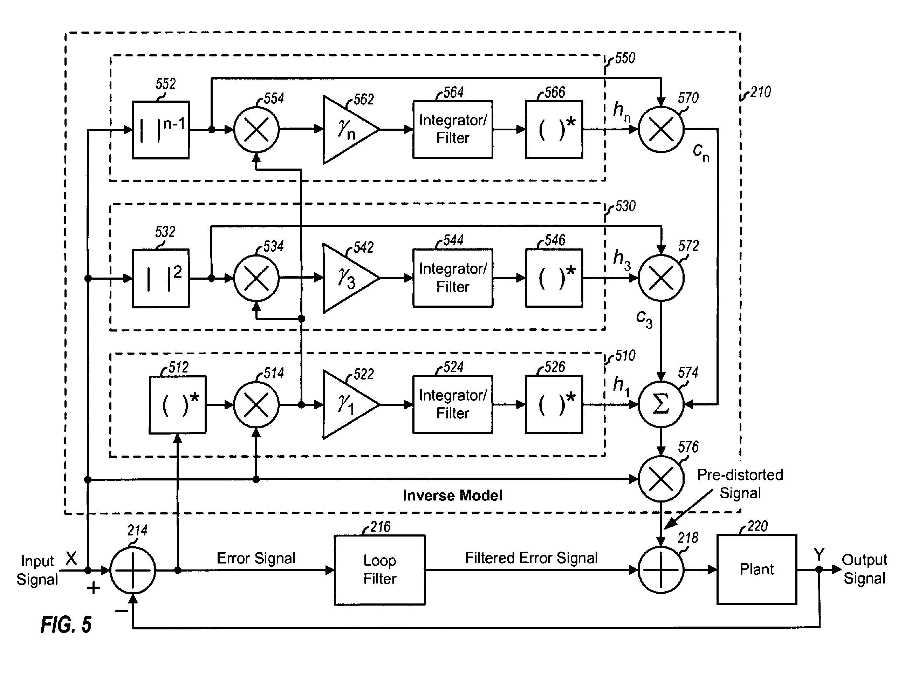

**FIG. 5** shows a block diagram of an exemplary design of adaptive inverse model 210 in FIG. 5. In this exemplary design, coefficient $h_1$ for the linear gain, coefficient $h_3$ for third order nonlinearity, and coefficient $h_n$ for $n$-th order nonlinearity are adaptively determined, where $n$ may be any integer value greater than one. Coefficients for nonlinearity of other orders are ignored.

Inverse model 210 includes an adaptation block 510 that adaptively determines coefficient $h_1$, an adaptation block 530 that adaptively determines coefficient $h_3$, and an adaptation block 550 that adaptively determines coefficient $h_n$. Within adaptation block 510, a unit 512 receives the error signal from summer 214 and provides the complex conjugate of the error signal. A multiplier 514 multiplies the input signal X with the output of unit 512. In another exemplary design, the error signal may be filtered before being applied to multiplier 514. In any case, a gain element 522 scales the output of multiplier 514 with an adaptation factor $\gamma_1$. An integrator/filter 524 integrates or filters the output of gain element 522, e.g., separately for the I and Q components. In general, any suitable filter function may be used for integrator/filter 524. A unit 526 provides the complex conjugate of the output of integrator/filter 524 as coefficient $h_1$.

Coefficient $h_1$ may be expressed in discrete time as followed:

$$h_1^*(t) = h_1^*(t-1) + \gamma_1 X(t-1) E^*(t-1) , \qquad Eq\ (7)$$

where $t$ is a variable for discrete time. Equation (7) has the form of a least mean square (LMS) algorithm. Adaptation factor $\gamma_1$ determines the rate of convergence of coefficient $h_1$ to a final value.

Within adaptation block 530, a unit 532 receives the input signal X and provides the magnitude squared of the input signal. A multiplier 534 multiplies the output of unit 532 with the output of multiplier 514. A gain element 542 scales the output of multiplier 534 with an adaptation factor $\gamma_3$. An integrator/filter 544 integrates or filters the output of gain element 542, e.g., separately for the I and Q components. A unit 546 provides the complex conjugate of the output of integrator/filter 544 as coefficient $h_3$. A multiplier 572 multiplies coefficient $h_3$ with the output of unit 532 and provides a correction factor $c_3$.

Coefficient $h_3$ may be expressed in discrete time as followed:

$$h_3^*(t) = h_3^*(t-1) + \gamma_3 |X(t-1)|^2 X(t-1) E^*(t-1) . \qquad Eq\ (8)$$

Equation (8) also has the form of an LMS algorithm. Adaptation factor $\gamma_3$ determines the rate of convergence of coefficient $h_3$ to a final value.

Within adaptation block 550, a unit 552 receives the input signal X and provides the magnitude of the input signal raised to the $(n-1)$-th power. A multiplier 554 multiplies the output of unit 552 with the output of multiplier 514. A gain element 562 scales the output of multiplier 534 with an adaptation factor $\gamma_n$. An integrator/filter 564 integrates or filters the output of gain element 562, e.g., separately for the I and Q components. A unit 566 provides the complex conjugate of the output of integrator/ filter 544 as coefficient $h_n$. A multiplier 570 multiplies coefficient $h_n$ with the output

of unit 552 and provides a correction factor $c_n$.

In general, the inverse of the nonlinearity of plant 220 may be modeled as a polynomial, e.g., as shown in equation (6). One adaptation block may be used to adaptively determine the coefficient for each order of nonlinearity of interest. Coefficient $h_n$ for the $n$-th order nonlinearity (where $n$ may be 2, 3, 4, 5, etc.) may be adaptively determined by generating an $n$-th order input signal as $|X^{n-1}| \cdot X$, multiplying the $n$-th order input signal with the complex conjugate error signal E*, scaling the result with an adaptation factor $\gamma_n$, and integrating or filtering the scaled result to obtain the complex conjugate coefficient $h_n^*$. Correction factor $c_n$ for the $n$-th order nonlinearity may then be generated by multiplying $|X^{n-1}|$ with coefficient $h_n$.

A summer 574 sums coefficient $h_1$ from adaptation block 510 with correction factor $c_3$ from multiplier 572 and correction factor $c_n$ from multiplier 570. A multiplier 576 multiplies the output of summer 574 with the input signal X and provides the pre-distorted signal to summer 218.

FIG. 5 shows an exemplary design of adaptively determining coefficient $h_3$ used to compensate for third order nonlinearity of plant 220 and coefficient $h_n$ used to compensate for $n$-th order nonlinearity of plant 220. Coefficients $h_3$ and $h_n$ may also be adaptively determined in other manners, e.g., using other adaptive algorithms known in the art.

The techniques described herein for mitigating nonlinearity of circuits using both pre-distortion and feedback may be used for various electronics devices such as wireless communication devices, cellular phones, personal digital assistants (PDAs), handheld devices, wireless modems, laptop computers, cordless phones, broadcast receivers, Bluetooth devices, consumer electronics devices, etc. For clarity, the use of the techniques in a wireless communication device, which may be a cellular phone or some other device, is described below.

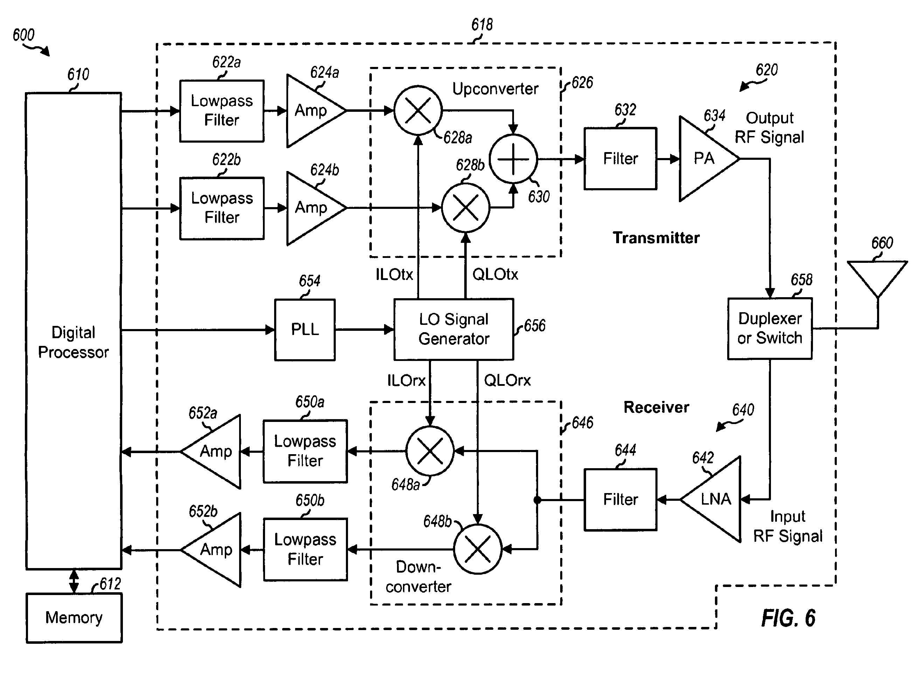

**FIG. 6** shows a block diagram of an exemplary design of a wireless communication device 600, which may be a cellular phone or some other device. In the exemplary design shown in FIG. 6, wireless device 600 includes a digital processor 610, a memory 612, and a transceiver 618. Transceiver 618 includes a transmitter 620 and a receiver 640 and that support bi-directional communication. In general, wireless device 600 may include any number of transmitters and any number of receivers for any number of communication systems and any number of frequency bands.

A transmitter or a receiver may be implemented with a super-heterodyne architecture or a direct-conversion architecture. In the super-heterodyne architecture, a signal is frequency converted between baseband and RF in multiple stages, e.g., from baseband to an intermediate frequency (IF) in one stage, and then from IF to RF in another stage for a transmitter. In the direct-conversion architecture, a signal is frequency converted between baseband and RF in one stage. The super-heterodyne and direct-conversion architectures may use different circuit blocks and/or may have different requirements. In the exemplary design shown in FIG. 6, transmitter 620 and receiver 640 are implemented with the direct-conversion architecture.

In the transmit path, digital processor 610 processes data to be transmitted and provides I and Q baseband signals to transmitter 620. Within transmitter 620, lowpass filters 622a and 622b filter the I and Q baseband signals, respectively, to remove undesired images caused by the prior digital-to-analog conversion. Amplifiers (Amp) 624a and 624b amplify the signals from lowpass filters 622a and 622b, respectively, and provide I and Q amplified signals. An upconverter 626 receives the I and Q amplified signals and I and Q transmit local oscillator (LO) signals (ILOtx and QLOtx) from an LO signal generator 656. Within upconverter 626, a mixer 628a upconverts the I amplified signal with the ILOtx signal, a mixer 628b upconverts the Q amplified signal with the QLOtx signal, and a summer 630 sums the outputs of mixers 628a and 628b and provides an upconverted signal. A filter 632 filters the upconverted signal to remove images caused by the frequency upconversion as well as noise in a receive frequency band. A power amplifier (PA) 634 amplifies the signal from filter 632 to obtain the desired output power level and provides an output RF signal. Power amplifier 634 may include a driver amplifier, one or more power amplifier stages, etc. The output RF signal is routed through a duplexer/switch 658 and transmitted via an antenna 660.

In the receive path, antenna 660 receives signals transmitted by base stations and/or other transmitter stations and provides an input RF signal, which is routed through duplexer/switch 658 and provided to receiver 640. Within receiver 640, the input RF signal is amplified by a low noise amplifier (LNA) 642 and filtered by a filter 644 to obtain a filtered RF signal. A downconverter 646 receives the filtered RF signal and I and Q receive LO signals (ILOrx and QLOrx) from LO signal generator 656. Within downconverter 646, a mixer 648a downconverts the filtered RF signal with the ILOrx signal and provides an I downconverted signal. A mixer 648b downconverts the filtered RF signal with the QLOrx signal and provides a Q downconverted signal. Lowpass filters 650a and 650b filter the I and Q downconverted signals, respectively, to remove undesired signal components and noise and provide I and Q filtered signals. Amplifiers 652a and 652b amplify the I and Q filtered signals, respectively, to obtain the desired signal amplitude and provide I and Q input baseband signals to digital processor 610.

LO signal generator 656 generates the ILOtx and QLOtx signals used by transmitter 620 for frequency upconversion as well as the ILOrx and QLOrx signals used by receiver 640 for frequency downconversion. A phase locked loop (PLL) 654 receives timing information from digital processor 610 and generates control signals used to adjust the frequency and/or phase of the LO signals provided by LO signal generator 656.

FIG. 6 shows an exemplary design of a transmitter and a receiver. In general, the conditioning of the signals in a transmitter and a receiver may be performed by one or more stages of amplifier, filter, upconverter, downconverter, etc. These circuit blocks may be arranged differently from the configuration shown in FIG. 6. Furthermore, other circuit blocks not shown in FIG. 6 may also be used to condition the signals in the transmitter and receiver. Some circuit blocks in FIG. 6 may also be omitted. All or a portion of transceiver 618 may be implemented on one or more analog integrated circuits (ICs), RF ICs (RFICs), mixed-signal ICs, etc.

Digital processor 610 may include various processing units for data transmission and reception and other functions. Memory 612 may store program codes and data for wireless device 600. Digital processor 610 and/or memory 612 may be implemented on one or more application specific integrated circuits (ASICs) and/or other ICs.

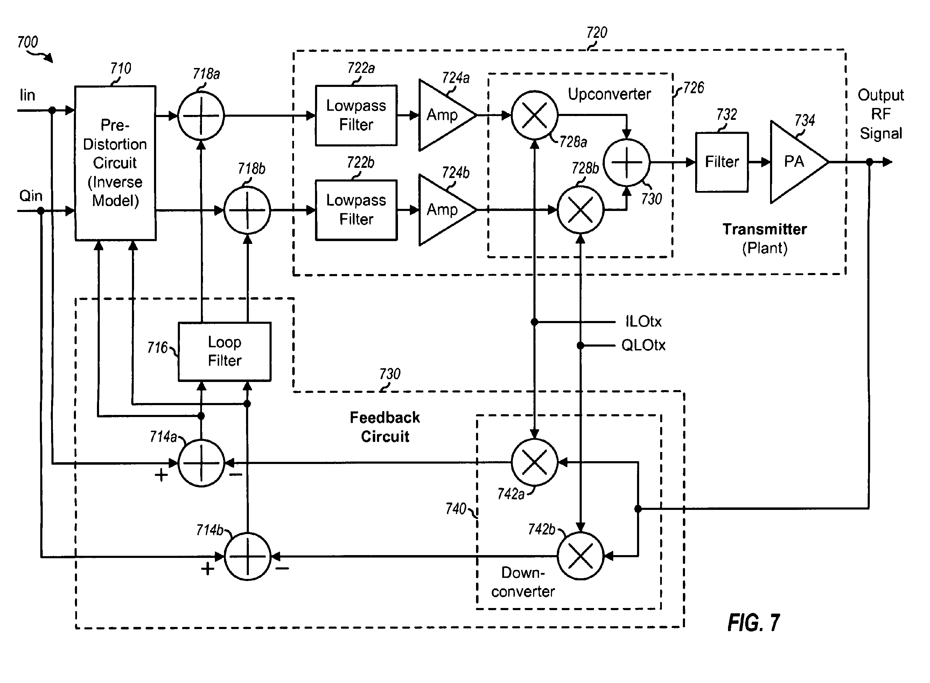

FIG. 7 shows a block diagram of an exemplary design of a transmitter system 700 with both pre-distortion and feedback to mitigate nonlinearity of a transmitter 720. Transmitter 720 has nonlinearity to be mitigated and may correspond to plant 220 in FIG. 4. Transmitter 720 includes lowpass filters 722a and 722b, amplifiers 724a and 724b, an upconverter 726 comprising mixers 728a and 728b and a summer 730, a filter 732, and a power amplifier 734, which may operate as described above for circuit blocks 622 through 634 within transmitter 620 in FIG. 6. Transmitter system 700 further includes other circuit blocks to implement pre-distortion and feedback.

In the feed-forward path, the I baseband signal (Iin) and the Q baseband signal (Qin) are provided to a pre-distortion circuit 710, which may correspond to inverse model 210 in FIG. 4. Pre-distortion circuit 710 pre-processes the Iin and Qin signals for pre-distortion and provides I and Q pre-distorted signals. A summer 718a sums the I pre-distorted signal and an I filtered error signal from a loop filter 716 and provides an I combined signal. Similarly, a summer 718b sums the Q pre-distorted signal and a Q filtered error signal from loop filter 716 and provides a Q combined signal. Loop filter 716 may correspond to loop filter 216 in FIG. 4, and real summers 718a and 718b may correspond to complex summer 218 in FIG. 4. The I and Q combined signals are provided to transmitter 720.

In the feedback path, a feedback circuit 730 receives the I and Q baseband signals and the output RF signal and generates the I and Q filtered error signals. Feedback circuit 730 includes real summers 714a and 714b, loop filter 716, and a downconverter 740. Within feedback circuit 730, the output RF signal from power amplifier 734 is downconverted from RF to baseband by downconverter 740. Within downconverter 740, the output RF signal is downconverted by a mixer 742a with the ILOtx signal to obtain an I feedback signal. The output RF signal is also downconverted by a mixer 742b with the QLOtx signal to obtain a Q feedback signal. The ILOtx and QLOtx signals used for upconverter 726 are also used for downconverter 740 (possibly with buffering not shown in FIG. 7). Summer 714a subtracts the I feedback signal from the I baseband signal and provides an I error signal to pre-distortion circuit 710 and loop filter 716. Summer 714b subtracts the Q feedback signal from the Q baseband signal and provides a Q error signal to pre-distortion circuit 710 and loop filter 716. Real summers 714a and 714b. may correspond to complex summer 214 in FIG. 4. Loop filter 716 may correspond to loop filter 216 in FIG. 4.

Pre-distortion circuit 710 adaptively determines coefficients $h_1$ and $h_3$ (and possibly coefficients for other nonlinearity terms) for transmitter 720. Pre-distortion circuit 710 then pre-processes the I and Q baseband signals based on the coefficients to obtain the I and Q pre-distorted signals. Pre-distortion circuit 710 may be implemented as illustrated in FIG. 5, which shows an exemplary design of complex inverse model 210. Each signal path within inverse model 210 in FIG. 5 may be for a complex signal comprising I and Q components. Each circuit block within inverse model 210 may operate on complex input signals and provide a complex output signal. Integrators/ filters 524, 544 and 564 may each include separate paths for I and Q components.

FIG. 7 shows an exemplary design of mitigating nonlinearity of transmitter 720 with pre-distortion and feedback. Pre-distortion and feedback may also be used for other circuits in the transmitter. For example, pre-distortion and feedback may be used for (i) only power amplifier 734, (ii) a combination of upconverter 726, filter 732 and power amplifier 734, (iii) a combination of amplifiers 724, upconverter 726, filter 732 and power amplifier 734, or (iv) some other combination of circuits.

Pre-distortion and feedback may also be used for circuits in the receiver. For example, pre-distortion and feedback may be used for (i) LNA 642 in FIG. 6, (ii) a combination of LNA 642, filter 644, and downconverter 646, (iii) LNA 642 through amplifiers 652, or (iv) some other combination of circuits.

In an exemplary design, an apparatus may comprise at least one circuit, a pre-distortion circuit, and a feedback circuit, e.g., as shown in FIG. 4 or 7. The circuit(s) may comprise a transmitter for a wireless communication device, a power amplifier, an upconverter, some other circuit, or any combination thereof. The circuit(s) may generate an output signal having distortion components due to their nonlinearity. The pre-distortion circuit may receive an input signal and generate a pre-distorted signal based on at least one coefficient determined by the nonlinearity of the circuit(s). The feedback circuit may generate a filtered error signal based on the input signal and the output signal. The circuit(s) may process the pre-distorted signal and the filtered error signal to generate the output signal, which may have attenuated distortion components due to the pre-distortion circuit and the feedback circuit. The feedback circuit may attenuate distortion components within its closed-loop bandwidth. The pre-distortion circuit may attenuate distortion components outside of the closed-loop bandwidth of the feedback circuit. The various signals may be real signals or complex signals.

The apparatus may further comprise a summer (e.g., complex summer 218 in FIG. 4 or real summers 718a and 718b in FIG. 7), which may sum the pre-distorted signal with the filtered error signal to generate a combined signal. The circuit(s) may then process the combined signal to generate the output signal.

In an exemplary design, the feedback circuit may comprise a summer and a loop filter. The summer (e.g., complex summer 214 in FIG. 4 or real summers 714a and 714b in FIG. 7) may subtract a version of the output signal from the input signal to generate an error signal. The loop filter (e.g., loop filter 216 in FIG. 4 or loop filter 716 in FIG. 7) may filter the error signal to generate the filtered error signal. If the circuit(s) includes an upconverter, then the feedback circuit may include a downconverter (e.g., downconverter 740 in FIG. 7). The downconverter may downconvert the output signal with an LO signal (which may also be used for the upconverter) to generate a downconverted signal. The summer may then subtract the downconverted signal from the input signal to generate the error signal.

The pre-distortion circuit may estimate an inverse of a transfer function of the circuit(s) and may process the input signal based on the estimated inverse of the transfer function to generate the pre-distorted signal. In an exemplary design, the pre-distortion circuit may adaptively determine the at least one coefficient for at least one nonlinearity term of the circuit(s) and may generate the pre-distorted signal based on the coefficient(s), e.g., as shown in FIG. 5. For example, the pre-distortion circuit may adaptively determine a coefficient $h_3$ for third order nonlinearity of the circuit(s) and may generate the pre-distorted signal based on coefficient $h_3$. In general, the pre-distortion circuit may adaptively determine a coefficient $h_n$ for $n$-th order nonlinearity of the circuit(s) by determining an intermediate signal (e.g., $|X^{n-1}| \cdot X \cdot E^*$) based on the input signal and an error signal, scaling the intermediate signal with a scaling factor to obtain a scaled signal, and filtering the scaled signal to obtain coefficient $h_n$ for the $n$-th order nonlinearity, where $n > 1$. The intermediate signal may be determined by multiplying the input signal with both the error signal and the magnitude of the input signal raised to the ($n$-1)-th power. The pre-distortion circuit may multiply coefficient $h_n$ for the $n$-th order nonlinearity with the magnitude of the input signal raised to the ($n$-1)-th power to obtain a correction factor $c_n$ for the $n$-th order nonlinearity. The pre-distorted signal may be generated based on the input signal and the correction factors for all nonlinearity terms.

In an exemplary design, a wireless communication device may comprise an upconverter, a power amplifier, a pre-distortion circuit, and a feedback circuit, e.g., as shown in FIG. 7. The upconverter may upconvert a baseband signal with an LO signal and may provide an upconverted signal. The power amplifier may amplify the upconverted signal and provide an output RF signal having distortion components due to nonlinearity of the power amplifier and nonlinearity of the upconverter. The pre-distortion circuit may receive an input signal and generate a pre-distorted signal based on at least one coefficient determined by the nonlinearity of the power amplifier and the nonlinearity of the upconverter. The feedback circuit may generate a filtered error signal based on the input signal and the output RF signal. The baseband signal may be generated based on the pre-distorted signal and the filtered error signal.

In an exemplary design, the feedback circuit may comprise a downconverter, a summer, and a loop filter. The downconverter may downconvert the output RF signal with the LO signal used for the upconverter and may provide a feedback signal. The summer may subtract the feedback signal from the input signal to generate an error signal. The loop filter may filter the error signal to generate the filtered error signal.

In an exemplary design, the pre-distortion circuit may adaptively determine the at least one coefficient for at least one nonlinearity term of the power amplifier and the upconverter and may generate the pre-distorted signal based on the at least one coefficient. The pre-distortion circuit may adaptively determine the coefficient for each nonlinearity term as described above.

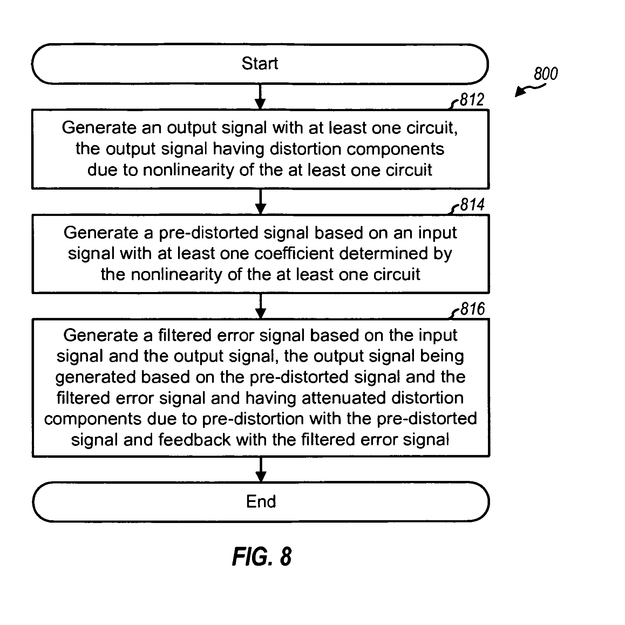

**FIG. 8** shows an exemplary design of a process 800 for generating an output signal with both pre-distortion and feedback. The output signal may be generated with at least one circuit and may have distortion components due to nonlinearity of the circuit(s) (block 812). A pre-distorted signal may be generated based on an input signal with at least one coefficient determined by the nonlinearity of the circuit(s) (block 814). In an exemplary design, the at least one coefficient may be adaptively determined for at least one nonlinearity term of the circuit(s), e.g., as described above. A filtered error signal may be generated based on the input signal and the output signal (block 816). The filtered error signal may be generated by (i) subtracting a version of the output signal from the input signal to obtain an error signal and (ii) filtering the error signal to obtain the filtered error signal. The output signal may be generated based on the pre-distorted signal and the filtered error signal and may have attenuated distortion components due to pre-distortion with the pre-distorted signal and feedback with the filtered error signal.

In an exemplary design, the circuit(s) may comprise a power amplifier. For block 812, an upconverted signal may be amplified with the power amplifier to generate the output signal. The upconverted signal may be generated based on the pre-distorted signal and the filtered error signal. The coefficient(s) may be determined by the nonlinearity of the power amplifier.

In another exemplary design, the circuit(s) may comprise an upconverter and a power amplifier. For block 812, a baseband signal may be upconverted with the upconverter to obtain an upconverted signal. The baseband signal may be generated based on the pre-distorted signal and the filtered error signal. The upconverted signal may be amplified with the power amplifier to generate the output signal. The coefficient(s) may be determined by the nonlinearity of both the upconverter and the power amplifier. The circuit(s) may also comprise other types of circuit.

A system with both pre-distortion and feedback described herein may be implemented on an IC, an analog IC, an RFIC, a mixed-signal IC, an ASIC, a printed circuit board (PCB), an electronics device, etc. The system with pre-distortion and feedback may also be fabricated with various IC process technologies such as complementary metal oxide semiconductor (CMOS), N-channel MOS (NMOS), P-channel MOS (PMOS), bipolar junction transistor (BJT), bipolar-CMOS (BiCMOS), silicon germanium (SiGe), gallium arsenide (GaAs), etc.

An apparatus implementing the system with pre-distortion and feedback described herein may be a stand-alone device or may be part of a larger device. A device may be (i) a stand-alone IC, (ii) a set of one or more ICs that may include memory ICs for storing data and/or instructions, (iii) an RFIC such as an RF receiver (RFR) or an RF transmitter/receiver (RTR), (iv) an ASIC such as a mobile station modem (MSM), (v) a module that may be embedded within other devices, (vi) a receiver, cellular phone, wireless device, handset, or mobile unit, (vii) etc.

In one or more exemplary designs, the functions described may be implemented in hardware, software, firmware, or any combination thereof. If implemented in software, the functions may be stored on or transmitted over as one or more instructions or code on a computer-readable medium. Computer-readable media includes both computer storage media and communication media including any medium that facilitates transfer of a computer program from one place to another. A storage media may be any available media that can be accessed by a computer. By way of example, and not limitation, such computer-readable media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Also, any connection is properly termed a computer-readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, includes compact disc (CD), laser disc, optical disc, digital versatile disc (DVD), floppy disk and blu-ray disc where *disks* usually reproduce data magnetically, while *discs* reproduce data optically with lasers. Combinations of the above should also be included within the scope of computer-readable media.

The previous description of the disclosure is provided to enable any person skilled in the art to make or use the disclosure. Various modifications to the disclosure will be readily apparent to those skilled in the art, and the generic principles defined herein may be applied to other variations without departing from the scope of the disclosure. Thus, the disclosure is not intended to be limited to the examples and designs described herein but is to be accorded the widest scope consistent with the principles and novel features disclosed herein.

## Claims

1. An apparatus comprising:

   means for generating (220) an output signal having distortion components due to nonlinearity of the means for generating the output signal;
   means for generating (210) a pre-distorted signal based on an input signal with at least one coefficient determined by the nonlinearity of the means for generating the output signal, the means for generating the pre-distorted signal comprises means for adaptively determining the at least one coefficient for at least one nonlinearity term of the means for generating the output signal; and
   means for generating (230) a filtered error signal based on the input signal and the output signal, the output signal being generated based on the pre-distorted signal and the filtered error signal and having attenuated distortion components due to pre-distortion with the pre-distorted signal and feedback with the filtered error signal.

2. The apparatus of claim 1, wherein:

   the means for generating an output signal is at least one circuit (220);
   the means for generating a pre-distorted signal is a pre-distortion circuit (210); and
   the means for generating a filtered error signal is a feedback circuit (230) coupled to the at least one circuit (220) .

3. The apparatus of claim 2, further comprising:

   a summer (218) coupled to the pre-distortion circuit (210) and the feedback circuit (230) and summing the pre-distorted signal with the filtered error signal to generate a combined signal, the at least one circuit processing the combined signal to generate the output signal.

**4.** The apparatus of claim 2, the feedback circuit (230) comprising
a summer (214) subtracting a version of the output signal from the input signal to generate an error signal, and
a loop filter (216) coupled to the summer (214) and filtering the error signal to generate the filtered error signal.

**5.** The apparatus of claim 2, the pre-distortion circuit (732estimating an inverse of a transfer function of the at least one circuit and processing the input signal based on the estimated inverse of the transfer function to generate the pre-distorted signal.

**6.** The apparatus of claim 2, the pre-distortion circuit (210) adaptively determining a coefficient for third order nonlinearity of the at least one circuit and generating the pre-distorted signal based on the coefficient.

**7.** The apparatus of claim 2, the pre-distortion circuit (210) adaptively determining a coefficient for n-th order nonlinearity of the at least one circuit by determining an intermediate signal based on the input signal and an error signal, scaling the intermediate signal with a scaling factor to obtain a scaled signal, and filtering the scaled signal to obtain the coefficient for the n-th order nonlinearity, where n is an integer greater than one, and the error signal being generated based on the output signal and the input signal.

**8.** The apparatus of claim 7, the pre-distortion circuit (210) determining the intermediate signal by multiplying the input signal with the error signal and magnitude of the input signal raised to (n-1)-th power.

**9.** The apparatus of claim 7, the pre-distortion circuit (210) multiplying the coefficient for the n-th order nonlinearity with magnitude of the input signal raised to (n-1)-th power to obtain a correction factor for the n-th order nonlinearity.

**10.** The apparatus of claim 2, the at least one circuit (220) comprising a transmitter (720) for a wireless communication device (700), and/or a power amplifier (734).

**11.** The apparatus of claim 2, the at least one circuit (220) comprising an upconverter (626) and a power amplifier (634).

**12.** The apparatus of claim 11, the feedback circuit (230) comprising
a downconverter (646) downconverting the output signal from the power amplifier with an local oscillator (LO) signal to generate a downconverted signal, the LO signal also being used for the upconverter,
a summer (coupled to the downconverter and subtracting the downconverted signal from the input signal to generate an error signal, and
a loop filter coupled to the summer and filtering the error signal to generate the filtered error signal.

**13.** The apparatus of claim 2, the feedback circuit (230) attenuating distortion components within a closed-loop bandwidth of the feedback circuit, and the pre-distortion circuit (210) attenuating distortion components outside of the closed-loop bandwidth.

**14.** A method comprising:

generating (812) an output signal with at least one circuit, the output signal having distortion components due to nonlinearity of the at least one circuit;
generating (814) a pre-distorted signal based on an input signal with at least one coefficient determined by the nonlinearity of the at least one circuit, the generating the pre-distorted signal comprises adaptively determining the at least one coefficient for at least one nonlinearity term of the at least one circuit; and
generating (816) a filtered error signal based on the input signal and the output signal, the output signal being generated based on the pre-distorted signal and the filtered error signal and having attenuated distortion components due to pre-distortion with the pre-distorted signal and feedback with the filtered error signal.

**15.** The method of claim 14, the generating the filtered error signal comprises
subtracting a version of the output signal from the input signal to obtain an error signal, and
filtering the error signal to obtain the filtered error signal.

**16.** The method of claim 14, the at least one circuit comprising a power amplifier, and the generating the output signal with the at least one circuit comprises
amplifying an upconverted signal with the power amplifiers to generate the output signal, the upconverted signal being generated based on the pre-distorted signal and the filtered error signal, and the at least one coefficient being determined by nonlinearity of the power amplifier.

17. The method of claim 14, the at least one circuit comprising an upconverter and a power amplifier, and the generating the output signal with the at least one circuit comprises
upconverting a baseband signal with the upconverter to obtain an upconverted signal, the baseband signal being generated based on the pre-distorted signal and the filtered error signal, and
amplifying the upconverted signal with the power amplifier to generate the output signal, the at least one coefficient being determined by nonlinearity of the upconverter and the power amplifier.

**Patentansprüche**

1. Eine Vorrichtung, die folgendes aufweist:

   Mittel (220) zum Generieren eines Ausgangssignals, das Verzerrungskomponenten aufgrund einer Nichtlinearität der Mittel zum Generieren des Ausgangssignals aufweist,
   Mittel (210) zum Generieren eines vorverzerrten Signals basierend auf einem Eingangssignal, wobei wenigstens ein Koeffizient durch die Nichtlinearität der Mittel zum Generieren des Ausgangssignals bestimmt wird, wobei die Mittel zum Generieren des vorverzerrten Signals Mittel zum adaptiven Bestimmen des wenigstens einen Koeffizienten für wenigstens einen Nichtlinearitätsterm der Mittel zum Generieren des Ausgangssignals aufweisen, und
   Mittel (230) zum Generieren eines gefilterten Fehlersignals basierend auf dem Eingangssignal und dem Ausgangssignal, wobei das Ausgangssignal basierend auf dem vorverzerrten Signal und dem gefilterten Fehlersignal generiert wird und gedämpfte Verzerrungskomponenten aufgrund der Vorverzerrung mit dem vorverzerrten Signal und der Rückkopplung mit dem gefilterten Fehlersignal aufweist.

2. Vorrichtung nach Anspruch 1, wobei:

   die Mittel zum Generieren eines Ausgangssignals wenigstens eine Schaltung (220) sind,
   die Mittel zum Generieren eines vorverzerrten Signals eine Vorverzerrungsschaltung (210) sind,
   die Mittel zum Generieren eines gefilterten Fehlersignals eine Rückkopplungsschaltung (230), die mit der wenigstens einen Schaltung (220) gekoppelt ist, sind.

3. Vorrichtung nach Anspruch 2, die weiterhin aufweist:

   einen Summierer (218), der mit der Vorverzerrungsschaltung (210) und der Rückkopplungsschaltung (230) gekoppelt ist und das vorverzerrte Signal mit dem gefilterten Fehlersignal summiert, um ein kombiniertes Signal zu generieren, wobei die wenigstens eine Schaltung das kombinierte Signal verarbeitet, um das Ausgangssignal zu generieren.

4. Vorrichtung nach Anspruch 2, wobei die Rückkopplungsschaltung (230) aufweist:

   einen Summierer (214), der eine Version des Ausgangssignals von dem Eingangssignal subtrahiert, um ein Fehlersignal zu generieren, und
   ein Schleifenfilter (216), das mit dem Summierer (214) gekoppelt ist und das Fehlersignal filtert, um das gefilterte Fehlersignal zu generieren.

5. Vorrichtung nach Anspruch 2, wobei die Vorverzerrungsschaltung (732) einen Kehrwert einer Übertragungsfunktion der wenigstens einen Schaltung schätzt und das Eingangssignal basierend auf dem geschätzten Kehrwert der Übertragungsfunktion verarbeitet, um das vorverzerrte Signal zu generieren.

6. Vorrichtung nach Anspruch 2, wobei die Vorverzerrungsschaltung (210) adaptiv einen Koeffizienten für eine Nichtlinearität der dritten Ordnung der wenigstens einen Schaltung bestimmt und das vorverzerrte Signal basierend auf dem Koeffizienten generiert.

7. Vorrichtung nach Anspruch 2, wobei die Vorverzerrungsschaltung (210) adaptiv einen Koeffizienten für die Nichtlinearität der n-ten Ordnung der wenigstens einen Schaltung bestimmt, indem sie ein Zwischensignal basierend auf dem Eingangssignal und einem Fehlersignal bestimmt, das Zwischensignal mit einem Skalierungsfaktor skaliert, um ein skaliertes Signal zu erhalten, und das skalierte Signal filtert, um den Koeffizienten für die Nichtlinearität der n-ten Ordnung zu erhalten, wobei n eine Ganzzahl größer als eins ist und das Fehlersignal basierend auf dem Ausgangssignal und dem Eingangssignal generiert wird.

8. Vorrichtung nach Anspruch 7, wobei die Vorverzerrungsschaltung (210) das Zwischensignal bestimmt, indem sie das Eingangssignal mit dem Fehlersignal und der Größe des zu der (n-1)-ten Potenz erhöhten Eingangssignals multipliziert.

9. Vorrichtung nach Anspruch 7, wobei die Vorverzerrungsschaltung (210) den Koeffizienten für die Nichtlinearität der n-ten Ordnung mit der Größe des zu der (n-1)-ten Potenz erhöhten Eingangssignals multipliziert, um einen Korrekturfaktor für die Nichtlinearität der n-ten Ordnung zu erhalten.

10. Vorrichtung nach Anspruch 2, wobei die wenigstens eine Schaltung (220) einen Sender (720) für ein drahtloses Kommunikationsgerät (700) und/oder einen Leistungsverstärker (734) aufweist.

11. Vorrichtung nach Anspruch 2, wobei die wenigstens eine Schaltung (220) einen Aufwärtswandler (626) und einen Leistungsverstärker (634) aufweist.

12. Vorrichtung nach Anspruch 11, wobei die Rückkopplungsschaltung (230) aufweist:

einen Abwärtswandler (646), der das Ausgangssignal aus dem Leistungsverstärker mit einem Lokaloszillator (LO)-Signal abwärtswandelt, um ein abwärtsgewandeltes Signal zu generieren, wobei das LO-Signal auch für den Aufwärtswandler verwendet wird,
einen Summierer, der mit dem Abwärtswandler gekoppelt ist und das abwärtsgewandelte Signal von dem Eingangssignal subtrahiert, um ein Fehlersignal zu generieren, und
ein Schleifenfilter, das mit dem Summierer gekoppelt ist und das Fehlersignal filtert, um das gefilterte Fehlersignal zu generieren.

13. Vorrichtung nach Anspruch 2, wobei die Rückkopplungsschaltung (230) Verzerrungskomponenten innerhalb einer Geschlossener-Regelkreis-Bandbreite der Rückkopplungsschaltung dämpft und die Vorverzerrungsschaltung (210) Verzerrungskomponenten außerhalb der Geschlossener-Regelkreis-Bandbreite dämpft.

14. Ein Verfahren, das folgende Schritte aufweist:

Generieren (812) eines Ausgangssignals durch wenigstens eine Schaltung, wobei das Ausgangssignal Verzerrungskomponenten aufgrund einer Nichtlinearität der wenigstens einen Schaltung aufweist,
Generieren (814) eines vorverzerrten Signals basierend auf einem Eingangssignal, wobei wenigstens ein Koeffizient durch die Nichtlinearität der wenigstens einen Schaltung bestimmt wird, wobei das Generieren des vorverzerrten Signals das adaptive Bestimmen des wenigstens einen Koeffizienten für wenigstens einen Nichtlinearitätsterm der wenigstens einen Schaltung aufweist, und
Generieren (816) eines gefilterten Fehlersignals basierend auf dem Eingangssignal und dem Ausgangssignal, wobei das Ausgangssignal basierend auf dem vorverzerrten Signal und dem gefilterten Fehlersignal generiert wird und gedämpfte Verzerrungskomponenten aufgrund der Vorverzerrung mit dem vorverzerrten Signal und der Rückkopplung mit dem gefilterten Fehlersignal aufweist.

15. Verfahren nach Anspruch 14, wobei das Generieren des gefilterten Fehlersignals aufweist:

Subtrahieren einer Version des Ausgangssignals von dem Eingangssignal, um ein Fehlersignal zu erhalten, und
Filtern des Fehlersignals, um das gefilterte Fehlersignal zu erhalten.

16. Verfahren nach Anspruch 14, wobei die wenigstens eine Schaltung einen Leistungsverstärker aufweist und wobei das Generieren des Ausgangssignals durch die wenigstens eine Schaltung aufweist:

Verstärken eines aufwärtsgewandelten Signals durch den Leistungsverstärker, um das Ausgangssignal zu generieren, wobei das aufwärtsgewandelte Signal basierend auf dem vorverzerrten Signal und dem gefilterten Fehlersignal generiert wird und wobei der wenigstens eine Koeffizient durch eine Nichtlinearität des Leistungsverstärkers bestimmt wird.

**17.** Verfahren nach Anspruch 14, wobei die wenigstens eine Schaltung einen Aufwärtswandler und einen Leistungsverstärker aufweist und wobei das Generieren des Ausgangssignals durch die wenigstens eine Schaltung aufweist:

Aufwärtswandeln eines Basisbandsignals durch den Aufwärtswandler, um ein aufwärtsgewandeltes Signal zu erhalten, wobei das Basisbandsignal basierend auf dem vorverzerrten Signal und dem gefilterten Fehlersignal generiert wird, und

Verstärken des aufwärtsgewandelten Signals durch den Leistungsverstärker, um das Ausgangssignal zu generieren, wobei der wenigstens eine Koeffizient durch eine Nichtlinearität des Aufwärtswandlers und des Leistungsverstärkers bestimmt wird.

**Revendications**

**1.** Appareil comprenant :

des moyens pour générer (220) un signal de sortie ayant des composantes de distorsion dues à une non linéarité des moyens pour générer le signal de sortie ;

des moyens pour générer (210) un signal pré-distordu sur la base d'un signal d'entrée à l'aide d'au moins un coefficient déterminé par la non linéarité des moyens pour générer le signal de sortie, les moyens pour générer le signal pré-distordu comprenant des moyens pour déterminer de façon adaptative ledit au moins un coefficient pour au moins un terme de non linéarité des moyens pour générer le signal de sortie ; et

des moyens pour générer (230) un signal d'erreur filtré sur la base du signal d'entrée et du signal de sortie, le signal de sortie étant généré sur la base du signal pré-distordu et du signal d'erreur filtré et ayant des composantes de distorsion atténuées en raison de la pré-distorsion avec le signal pré-distordu et d'une contre-réaction avec le signal d'erreur filtré.

**2.** Appareil selon la revendication 1, dans lequel :

les moyens pour générer un signal de sortie sont au moins un circuit (220) ;

les moyens pour générer un signal pré-distordu sont un circuit de pré-distorsion (210) ; et

les moyens pour générer un signal d'erreur filtré sont un circuit de contre-réaction (230) couplé audit au moins un circuit (220).

**3.** Appareil selon la revendication 2, comprenant en outre :

un additionneur (218) couplé au circuit de pré-distorsion (210) et au circuit de contre-réaction (230) et faisant la somme du signal pré-distordu et du signal d'erreur filtré pour générer un signal combiné, ledit au moins un circuit traitant le signal combiné pour générer le signal de sortie.

**4.** Appareil selon la revendication 2, dans lequel le circuit de contre-réaction (230) comprend :

un additionneur (214) soustrayant une version du signal de sortie du signal d'entrée pour générer un signal d'erreur, et

un filtre de boucle (216) couplé à l'additionneur (214) et filtrant le signal d'erreur pour générer le signal d'erreur filtré.

**5.** Appareil selon la revendication 2, dans lequel le circuit de pré-distorsion (732) estime l'inverse d'une fonction de transfert dudit au moins un circuit et traite le signal d'entrée sur la base de l'inverse estimé de la fonction de transfert pour générer le signal pré-distordu.

**6.** Appareil selon la revendication 2, dans lequel le circuit de pré-distorsion (210) détermine de façon adaptative un coefficient pour la non linéarité du troisième ordre dudit au moins un circuit et génère le signal pré-distordu sur la base du coefficient.

**7.** Appareil selon la revendication 2, dans lequel le circuit de pré-distorsion (210) détermine de façon adaptative un coefficient pour la non linéarité d'ordre n dudit au moins un circuit en déterminant un signal intermédiaire sur la base du signal d'entrée et d'un signal d'erreur, en redimensionnant le signal intermédiaire avec un facteur d'échelle pour obtenir un signal redimensionné, et en filtrant le signal redimensionné pour obtenir le coefficient pour la non linéarité d'ordre n, où n est un entier supérieur à un, et le signal d'erreur étant généré sur la base du signal de sortie et du signal d'entrée.

8.  Appareil selon la revendication 7, dans lequel le circuit de pré-distorsion (210) détermine le signal intermédiaire en multipliant le signal d'entrée par le signal d'erreur et l'amplitude du signal d'entrée élevée à la puissance (n-1) .

9.  Appareil selon la revendication 7, dans lequel le circuit de pré-distorsion (210) multiplie le coefficient pour la non linéarité d'ordre n par l'amplitude du signal d'entrée élevée à la puissance (n-1) pour obtenir un facteur de correction pour la non linéarité d'ordre n.

10. Appareil selon la revendication 2, dans lequel ledit au moins un circuit (220) comprend un émetteur (720) pour un dispositif de communication sans fil (700), et/ou un amplificateur de puissance (734).

11. Appareil selon la revendication 2, dans lequel ledit au moins un circuit (220) comprend un élévateur en fréquence (626) et un amplificateur de puissance (634).

12. Appareil selon la revendication 11, dans lequel le circuit de contre-réaction (230) comprend :

    un abaisseur de fréquence (646) pour abaisser la fréquence du signal de sortie provenant de l'amplificateur de puissance à l'aide d'un signal d'oscillateur local (LO) pour générer un signal abaissé en fréquence, le signal LO étant aussi utilisé pour l'élévateur en fréquence,
    un additionneur couplé à l'abaisseur en fréquence et soustrayant le signal abaissé en fréquence du signal d'entrée pour générer un signal d'erreur, et
    un filtre de boucle couplé à l'additionneur et filtrant le signal d'erreur pour générer le signal d'erreur filtré.

13. Appareil selon la revendication 2, dans lequel le circuit de contre-réaction (230) atténue des composantes de distorsion dans une largeur de bande de boucle fermée du circuit de contre-réaction, et le circuit de pré-distorsion (210) atténue des composantes de distorsion en dehors de la largeur de bande de boucle fermée.

14. Procédé comprenant :

    générer (812) un signal de sortie à l'aide d'au moins un circuit, le signal de sortie ayant des composantes de distorsion dues à une non linéarité dudit au moins un circuit ;
    générer (814) un signal pré-distordu sur la base d'un signal d'entrée à l'aide d'au moins un coefficient déterminé par la non linéarité dudit au moins un circuit, la génération du signal pré-distordu comprenant de déterminer de façon adaptative ledit au moins un coefficient pour au moins un terme de non linéarité dudit au moins un circuit ; et
    générer (816) un signal d'erreur filtré sur la base du signal d'entrée et du signal de sortie, le signal de sortie étant généré sur la base du signal pré-distordu et du signal d'erreur filtré et ayant des composantes de distorsion atténuées en raison de la pré-distorsion avec le signal pré-distordu et d'une contre-réaction avec le signal d'erreur filtré.

15. Procédé selon la revendication 14, dans lequel la génération du signal d'erreur filtré comprend :

    soustraire du signal d'entrée une version du signal de sortie pour obtenir un signal d'erreur, et
    filtrer le signal d'erreur pour obtenir le signal d'erreur filtré.

16. Procédé selon la revendication 14, dans lequel ledit au moins un circuit comprend un amplificateur de puissance, et la génération du signal de sortie avec ledit au moins un circuit comprend
    amplifier un signal élevé en fréquence avec l'amplificateur de puissance pour générer le signal de sortie, le signal élevé en fréquence étant généré sur la base du signal pré-distordu et du signal d'erreur filtré, et ledit au moins un coefficient étant déterminé par la non linéarité de l'amplificateur de puissance.

17. Procédé selon la revendication 14, dans lequel ledit au moins un circuit comprend un élévateur en fréquence et un amplificateur de puissance, et la génération du signal de sortie avec ledit au moins un circuit comprend :

    élever en fréquence un signal de bande de base avec l'élévateur en fréquence pour obtenir un signal élevé en fréquence, le signal de bande de base étant généré sur la base du signal pré-distordu et du signal d'erreur filtré, et amplifier le signal élevé en fréquence avec l'amplificateur de puissance pour générer le signal de sortie, ledit au moins un coefficient étant déterminé par la non linéarité de l'élévateur en fréquence et de l'amplificateur de puissance.

Feed-Forward Path

X $\longrightarrow$ + $\bigoplus_{114}$ E $\longrightarrow$ Loop Filter **F'** $\longrightarrow$ $\bigoplus_{118}$ U $\longrightarrow$ Plant **P** $\longrightarrow$ Y

*116*  *120*

$-$

Feedback Gain **β**  *122*

Feedback Loop *130*

*100*

**FIG. 1**

Feed-Forward Path

X $\longrightarrow$ Model **M** $\longrightarrow$ + $\bigoplus_{214}$ E $\longrightarrow$ Loop Filter **F** $\longrightarrow$ $\bigoplus_{218}$ U $\longrightarrow$ Plant **P** $\longrightarrow$ Y

*212*  *216*  *220*

$-$

Feedback Loop *230*

*200*

**FIG. 2**

EP 2 446 530 B1

FIG. 3

FIG. 4

EP 2 446 530 B1

FIG. 5

*FIG. 6*

FIG. 7

```
┌─────────────────────────────────────────────────────────┐
│                         Start                            │         800
└─────────────────────────────────────────────────────────┘
                            │                    ┌812
                            ▼
┌─────────────────────────────────────────────────────────┐
│    Generate an output signal with at least one circuit,  │
│       the output signal having distortion components     │
│         due to nonlinearity of the at least one circuit  │
└─────────────────────────────────────────────────────────┘
                            │                    ┌814
                            ▼
┌─────────────────────────────────────────────────────────┐
│      Generate a pre-distorted signal based on an input   │
│      signal with at least one coefficient determined by  │
│          the nonlinearity of the at least one circuit    │
└─────────────────────────────────────────────────────────┘
                            │                    ┌816
                            ▼
┌─────────────────────────────────────────────────────────┐
│     Generate a filtered error signal based on the input  │
│     signal and the output signal, the output signal being│
│     generated based on the pre-distorted signal and the  │
│     filtered error signal and having attenuated distortion│
│     components due to pre-distortion with the pre-distorted│
│       signal and feedback with the filtered error signal │
└─────────────────────────────────────────────────────────┘
                            │
                            ▼
┌─────────────────────────────────────────────────────────┐
│                          End                             │
└─────────────────────────────────────────────────────────┘
```

**FIG. 8**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5745006 A